# FASCICULE DE BREVET EUROPEEN

(11) **EP 3 347 244 B1**
(45) Date de publication et mention de la délivrance du brevet: **12.06.2019**
(21) Numéro de dépôt: 16770069.9
(22) Date de dépôt: 31.08.2016
(51) Int. Cl.: B60R 16/023

(54) **DISPOSITIF ÉLÉCTRIQUE INCLINÉ AU-DESSUS D'UN PASSAGE DE ROUE DE VÉHICULE**
SCHRÄG OBERHALB EINES KRAFTFAHRZEUGRADKASTEN BEFESTIGTES ELEKTRISCHES GERÄT
ELECTRICAL DEVICE MOUNTED INCLINED ABOVE THE AREA OF A VEHICLE WHEEL

(30) Priorité: 10.09.2015 FR 1558430
(43) Date de publication de la demande: 18.07.2018
(73) Titulaire: Renault S.A.S., 92100 Boulogne-Billancourt (FR)
(72) Inventeur: GUIGNARD, Fabrice, 78280 Guyancourt (FR)
(86) Numéro de dépôt international: PCT/FR2016/052161
(87) Numéro de publication internationale: WO 2017/042455

(56) Documents cités:
- EP-A1- 1 182 093
- EP-A1- 1 403 144
- EP-A1- 2 186 686
- EP-A2- 2 267 855
- WO-A1-2012/104721
- DE-A1- 4 331 900
- DE-A1-102011 012 326
- DE-T5-112011 105 463

## Description

La présente invention a trait à l'agencement d'un boitier électrique dans le compartiment moteur d'un véhicule. Plus particulièrement, la présente invention concerne un véhicule à moteur dont le boitier électrique est agencé dans le compartiment moteur au-dessus du passage de roue et avec une inclinaison donnée.

Il est connu du document EP1403144 de disposer une boite de relai électrique dans le compartiment moteur en avant de la coupelle d'amortisseur, à proximité du capot. Cela permet une expulsion de la boite de relai vers le haut en cas de choc, et de protéger celle-ci d'une dégradation consécutive.

Cependant, un piéton qui viendrait à basculer sur le capot en cas de choc, risquerait d'être blessé par la boite relai, notamment au niveau de la tête.

Ce risque est d'autant plus élevé dans les véhicules de tourisme dont le capot est plongeant, et dont l'avant est amené à percuter les jambes d'un piéton adulte à mi-hauteur en cas de collision. Ce risque est d'autant plus élevé si ce boitier est métallique.

Le problème technique que vise à résoudre l'invention est donc d'agencer un dispositif électrique dans le compartiment moteur d'un véhicule, de manière à diminuer les risques de blessure d'un piéton, que pourrait causer ce dispositif électrique en cas de choc.

A cet effet, un premier objet de l'invention est un véhicule comprenant :
- un compartiment moteur,
- un dispositif électrique comprenant un boitier et des composants électriques et/ou électroniques enfermés dans le boitier,
ce boitier étant agencé dans le compartiment moteur au-dessus d'un passage de roue du véhicule et incliné vers le bas en s'éloignant de l'aile du véhicule la plus proche de ce passage de roue vers l'intérieur du compartiment moteur.

Ainsi, le dispositif électrique se situe dans une zone que le corps du piéton peut plus difficilement atteindre en cas de collision. Cette inclinaison permet de plus à ce qu'une première partie du boitier, agencée plus à l'intérieur du compartiment moteur, soit plus basse qu'une deuxième partie du boitier, agencée plus vers l'extérieur du compartiment moteur. De ce fait, plus on se rapproche de l'intérieur du compartiment moteur et plus le dispositif électrique, en particulier son boitier, est bas et difficile à atteindre par le corps d'un piéton en cas de choc.

L'invention peut optionnellement présenter une ou plusieurs des caractéristiques suivantes :
- le véhicule comprend une paroi de délimitation du passage de roue délimitant le compartiment moteur et le passage de roue ; dans le cadre de l'invention, cette paroi, lorsque le véhicule en est équipé, sert également de protection contre un accès mal intentionné au dispositif électrique par le dessous du compartiment moteur, accès déjà plus compliqué que par le dessus du compartiment moteur ;
- le jeu le plus faible entre le dispositif électrique et la paroi de délimitation du passage de roue est inférieur au jeu le plus faible entre le dispositif électrique et le capot ; ainsi, le dispositif électrique est plus proche du passage de roue que du capot, diminuant ainsi davantage le risque de contact avec un piéton en cas de choc ;

- la distance la plus petite entre le boitier et la première paroi de délimitation est d'au maximum 12 mm ;
- le boitier est métallique, notamment en aluminium ; l'invention est particulièrement avantageuse pour ce type de boitiers, qui constitue un risque de blessure aggravée pour un piéton ; il est donc utile de diminuer le risque de contact entre un piéton et ce boitier métallique ;
- le dispositif électrique est un dispositif de contrôle du moteur ; l'invention est particulièrement avantageuse pour un tel dispositif ; son boitier est en effet très résistant, pour protéger l'électronique qu'il contient ; souvent ce boitier est métallique, car outre qu'il protège les composants électroniques, celui-ci peut jouer le rôle de dissipateur thermique ; il est donc utile de diminuer le risque de contact entre un piéton et ce dispositif de contrôle du moteur;
- le boitier comprend au moins une connexion électrique destinée à être connectée électriquement à une alimentation électrique du véhicule, cette connexion électrique étant orientée vers le bas ; cela rend cette connexion difficile d'accès depuis le haut du compartiment moteur ; cela permet de protéger cette entrée de personnes mal intentionnées ; en particulier dans le cas d'un dispositif de contrôle du moteur cela protège davantage le véhicule contre le vol ;
- au moins une connexion électrique est agencée sur le côté le plus bas du boitier ; on rend ainsi l'accès à l'entrée électrique depuis le haut du compartiment moteur davantage compliqué ;
- le boitier comprend une face principale inférieure pourvue d'ailettes, ces ailettes s'étendant dans un espace agencé entre cette face principale inférieure, une paroi de délimitation du compartiment moteur et du passage de roue, et une paroi latérale du compartiment moteur ; ainsi on privilégie la dissipation thermique par le boitier vers une zone libre et non confinée, qui est de plus fraiche, comparée à la zone du compartiment moteur où est agencé le groupe motopropulseur ;
- le boitier comprend une ventilation communiquant entre l'extérieur et l'intérieur du boitier, ladite ventilation débouchant sur l'extérieur du boitier par une ouverture extérieure orientée vers le bas ; cela permet d'éviter que lors du nettoyage du groupe électromoteur avec des jets d'eau sous pression, de l'eau pénètre dans cette ventilation ;
- la ventilation peut être agencée pour déboucher dans un espace agencé entre une face principale inférieure du boitier, une paroi de délimitation du compartiment moteur et du passage de roue, et une paroi latérale du compartiment moteur ; cela permet de ventiler l'air à l'intérieur du boitier avec un air plus frais ;
- l'espace agencé entre une face principale inférieure du boitier, une paroi de délimitation du compartiment moteur et du passage de roue, et une paroi latérale du compartiment loge uniquement des éléments du dispositif électrique, notamment des ailettes, au moins une ventilation et/ou au moins un connecteur ; le refroidissement et/ou la ventilation sont ainsi plus efficaces, cet espace contenant plus d'air ;
- le boitier comprend deux faces principales, notamment environ parallèles, et des bords périphériques séparant ces deux faces principales ;
- l'une des faces principales est tournée vers le passage de roue ; cet agencement confère un encombrement minimal du boitier et facilite son agencement au-dessus et à proximité du passage de roue ;
- les faces principales sont environ parallèles à l'axe longitudinal du véhicule et inclinées vers un longeron longitudinal du châssis traversant le compartiment moteur ; le boitier présente ainsi un encombrement minimum au-dessus du passage de roue ;
- le dispositif électrique est situé en avant d'une coupelle d'amortisseur du véhicule ;
- le véhicule comprend une platine porteuse, notamment une plaque de tôle, fixée dans le compartiment moteur et portant le dispositif électrique ; c'est une manière simple de fixer le dispositif électrique dans le compartiment moteur avec une inclinaison donnée ; notamment l'une des faces principales du boitier peut être plaquée contre la platine porteuse ;
- la platine porteuse est fixée à une entretoise reliant l'aile du véhicule à un longeron du véhicule passant dans le compartiment moteur ;
- la platine porteuse est fixée à une coupelle d'amortisseur du véhicule ;
- la platine porteuse est fixée de part et d'autre du boitier à et entre deux parois transversales, agencées entre un longeron du véhicule, et l'aile du véhicule située du côté du passage de roue ; cela permet un maintien ferme du dispositif électrique, et résistant aux vibrations ;
- la platine porteuse peut comprendre quatre points de fixation, notamment à ses quatre coins ; cela renforce la résistance aux vibrations ; par exemple la platine porteuse peut être fixée par deux points à l'une des parois transversales et par deux points à l'autre des parois transversales ;
- l'une des parois transversales est la paroi d'une coupelle d'amortisseur du véhicule et l'autre paroi transversale est une entretoise reliant l'aile du véhicule au longeron ; on a ainsi une fixation et un agencement peu encombrant et résistant aux vibrations ;
- le dispositif électrique est fixé sous la platine porteuse ; on complique ainsi son accès par le haut du compartiment moteur ;
- le dispositif électrique est logé sous une boite contenant des moyens électriques supplémentaires, tels que des fusibles, des relais électriques et/ou des moyens de pilotage d'appareils électriques annexes du véhicule, tels que les essuie-glaces, les projecteurs, les feux arrières ou la climatisation de l'habitacle ; cela permet un meilleur agencement dans le compartiment moteur des différents moyens électriques et/ou mécaniques ; l'accès au dispositif électrique est ainsi plus difficile ;
- le véhicule comprend une batterie d'alimentation électrique, logée à l'arrière du compartiment moteur, notamment en vis-à-vis du tablier séparant le compartiment moteur de l'habitacle et avec une partie arrière de la batterie en vis-à-vis d'une des coupelles d'amortisseur.

D'autres caractéristiques et avantages de l'invention apparaîtront à la lecture de la description détaillée des exemples non limitatifs qui suivent, pour la compréhension de laquelle on se reportera aux dessins annexés, parmi lesquels :
- la figure 1 est une vue en perspective d'une partie du compartiment moteur d'un véhicule selon l'invention;
- la figure 2 est une vue de face de la figure 1;
- la figure 3 est une vue latérale de la figure 1 de la gauche vers la droite du véhicule avec les éléments latéraux du châssis non représentés ;
- la figure 4 est une vue latérale de la figure 1;
- la figure 5 correspond à la figure 1 mais avec la platine porteuse du dispositif électrique fixée au-dessus de ce dernier;
- la figure 6 est une vue sous un autre angle de la figure 5 mais avec l'alimentation électrique du véhicule et une boite représentées.

Dans la présente demande, les termes haut et bas sont utilisés par rapport au véhicule reposant avec ses roues sur un sol horizontal. Les termes avant, arrière, gauche et droite sont utilisés par rapport au sens de la conduite en marche avant.

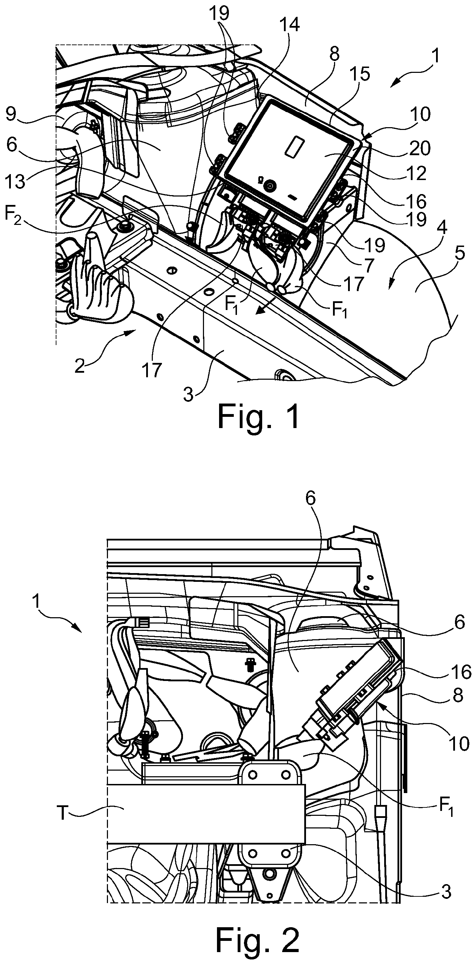

Les figures 1 et 2 illustrent la partie arrière gauche du compartiment moteur 2 d'un exemple de réalisation d'un véhicule 1 selon l'invention. Dans cet exemple, ce compartiment moteur 2 est situé à l'avant du véhicule et destiné à recevoir le groupe motopropulseur, non représenté.

La structure de base de support du châssis du véhicule 1, comprend deux longerons s'étendant de l'avant à l'arrière du véhicule et reliés entre eux par aux moins deux traverses. Sur ces figures, seule la partie avant du longeron gauche 3 du véhicule est illustrée. Certaines de ces figures illustrent la partie gauche de la traverse T.

Le longeron gauche 3 et la traverse avant T passent donc à l'intérieur du compartiment moteur 2.

Le véhicule 1 comprend un dispositif électrique 10 logé à l'intérieur du compartiment moteur 2. Dans cet exemple, ce dispositif électrique est un dispositif de contrôle du moteur 10, encore appelé calculateur moteur. Ce dispositif de contrôle du moteur 10 comprend un boîtier 20 à l'intérieur duquel sont logés différents composants électroniques, non visibles sur ces figures.

Dans cet exemple, le boîtier 20 comprend deux faces principales parallèles, à savoir une paroi principale inférieure 11, non visible en figures 1 et 2, et une face principale supérieure 12 séparées par quatre bords, à savoir un premier bord 13, un deuxième bord 14, un troisième bord 15 et un quatrième bord 16.

Le dispositif de contrôle du moteur 10, et en particulier l'agencement de ses différents composants électroniques permet un pilotage optimisé du groupe motopropulseur du véhicule 1. En particulier, il est apte à recueillir différentes données liées au moteur, à traiter ces données, et à envoyer des signaux de commande à différents organes du groupe motopropulseur de manière à pouvoir piloter ce dernier.

Pour ce pilotage, il est également apte à recevoir des signaux de commande provenant du tableau de bord, notamment de commandes actionnées par le conducteur du véhicule 1. Il est également apte à envoyer des signaux d'information vers le tableau de bord, notamment à destination du conducteur du véhicule, ou encore à d'autres calculateurs du véhicule.

Ces composants électroniques sont très actifs, et dégagent de la chaleur. De plus, comme ils sont confinés dans le boitier 20, il est nécessaire d'évacuer la chaleur de l'intérieur du boitier 20. Ce dernier est donc réalisé, de préférence, en un matériau conducteur de chaleur, souvent en métal, notamment en aluminium.

Le dispositif de contrôle du moteur 10, comprend différentes connexions électriques. Ces connexions électriques permettent de recevoir et d'envoyer les différents courants et signaux électriques nécessaires au pilotage du groupe motopropulseur. Pour cela, le boîtier 20 comprend des ouvertures permettant le passage de ces connexions électriques et/ou l'accès à ces dernières.

Ainsi dans cet exemple, le premier bord 13 du boîtier 20 du dispositif de contrôle du moteur comprend trois connecteurs comprenant chacun une pluralité de connexions électriques.

Deux premiers faisceaux électriques F1 sont branchés respectivement sur deux de ces connecteurs 17, dits ci-après connecteurs moteur. Ces premiers faisceaux électriques partent, comme l'indique la flèche noire correspondante, en direction du groupe motopropulseur, afin de véhiculer les différents signaux de commande et de données nécessaires au pilotage de ce groupe motopropulseur.

Le troisième connecteur, dit connecteur habitacle et non visible sur ces figures 1 et 2, reçoit un deuxième faisceau électrique F2, qui part, comme l'indique l'autre flèche noire, en direction du tablier 9, qui délimite le compartiment moteur 2 de l'habitacle, non représenté sur les figures. Ce deuxième faisceau électrique F2 conduit les signaux de commande et de données vers et depuis le tableau de bord.

Comme on peut le voir sur ces figures 1 et 2, le dispositif de contrôle du moteur 10 est agencé au-dessus d'un passage de roue 4 du véhicule 1, ici le passage de roue avant gauche. Notamment, sa face principale inférieure est tournée vers le passage de roue 4.

Le dispositif de contrôle du moteur 10 est également agencé de manière à ce que son boîtier 20 soit incliné vers le bas, en allant du troisième bord 15 vers le premier bord 13. C'est-à-dire que le premier bord 13 est plus bas que le troisième bord 15.

Le boitier 20 est donc incliné vers le bas selon une direction allant de l'aile gauche du véhicule 1 vers l'intérieur du compartiment moteur 2.

L'aile gauche n'est pas représentée sur les figures 1 et 2. En revanche les figures 1 et 2 illustrent une paroi latérale 8, sur laquelle l'aile est fixée. La paroi latérale 8 sert de délimitation latérale gauche entre l'intérieur et l'extérieur du compartiment moteur 2.

Une entretoise 7 permet de maintenir la plaque latérale 8 et lui permet de résister aux vibrations. Cette entretoise 7 est ici une plaque verticale, fixée d'un côté au longeron 3 et de l'autre à la paroi latérale 8.

Le passage de roue 4 correspond au volume destiné à recevoir la roue correspondante, ici la roue avant gauche, tout en permettant la rotation de celle-ci ainsi que ses débattements horizontaux et verticaux.

Ce passage de roue 4 peut être, comme dans l'exemple illustré, séparé du compartiment moteur 2 par une paroi de délimitation 5 du passage de roue.

Le dispositif de contrôle du moteur 10 est donc agencé en avant de la coupelle d'amortisseur avant gauche 6.

L'inclinaison du boitier 20, est telle que plus on s'éloigne de la paroi latérale 8 vers l'intérieur du compartiment moteur, plus le boîtier 20 est bas. De ce fait en cas de collision, si la tête d'un piéton, venait à enfoncer le capot avant du véhicule 1, la tête du piéton atteindrait difficilement le boîtier 20. En effet, celui-ci, de par son inclinaison et son agencement sur le passage de roue, est bien en-dessous du capot du véhicule, notamment dès qu'on s'éloigne de l'aile.

Dans cet exemple, le boîtier 20 est incliné de telle sorte qu'il penche en direction du longeron 3, ici pratiquement à 45°. Les faces principales sont donc inclinées à 45° par rapport à l'horizontale en direction du longeron 3. On diminue encore davantage le risque de collision.

Par ailleurs, de manière générale dans l'invention et plus particulièrement dans cet exemple, le boîtier 20 est agencé de manière à ce que son côté le plus haut, à savoir celui du côté de l'aile la plus proche, à savoir dans cet exemple le troisième bord 15, soit situé plus bas que le haut de la coupelle d'amortisseur correspondante 6.

Notamment, ce côté peut être placé plus bas qu'une surface théorique limite au-dessus de laquelle il est considéré que les points durs présentent un danger accru pour les piétons. Cette surface théorique est parfois appelée nappe piéton. La nappe piéton considérée peut, par exemple, être celle fixée par un ou des organismes de réglementation compétents pour les lieux où le véhicule 1 est amené à être utilisé.

Par ailleurs, l'inclinaison du boitier vers l'intérieur du compartiment moteur 2 permet d'agencer le boîtier au-dessus du passage de roue 4, en perdant le moins de place possible. Cela est renforcé dans cet exemple par l'inclinaison du boitier 20 en direction du longeron 3.

Plus particulièrement dans cet exemple, la partie la plus basse du dispositif de contrôle du moteur 10 présente un jeu limité par rapport à la paroi de délimitation 5 du passage de roue 4. Notamment cette distance peut être inférieure à 12 mm, dans cet exemple elle est de 10 mm environ.

Selon une réalisation de l'invention, un agencement optimal, mais non limitatif, est obtenu lorsque les premier et deuxième bords, 13, 15, sont longitudinaux, soit environ parallèles à l'axe longitudinal du véhicule, les faces principales présentant une inclinaison uniquement, ou essentiellement, latérale. C'est le cas dans cet exemple, où le premier bord 13, le deuxième bord 14, le troisième bord 15 et le quatrième bord 16 forment donc respectivement un bord latéral inférieur, un bord arrière, un bord latéral supérieur et un bord avant. Ces bords seront désignés ci-après sous ces termes.

Le boîtier 20 présente sur son bord arrière 14 et sur son bord avant 16 des oreilles de fixation 19, permettant de fixer le dispositif de contrôle du moteur 10, comme il sera expliqué plus loin. Elles peuvent présenter chacune deux trous traversants, pour permettre d'ajuster la fixation de manière adaptée au véhicule recevant le dispositif de contrôle du moteur.

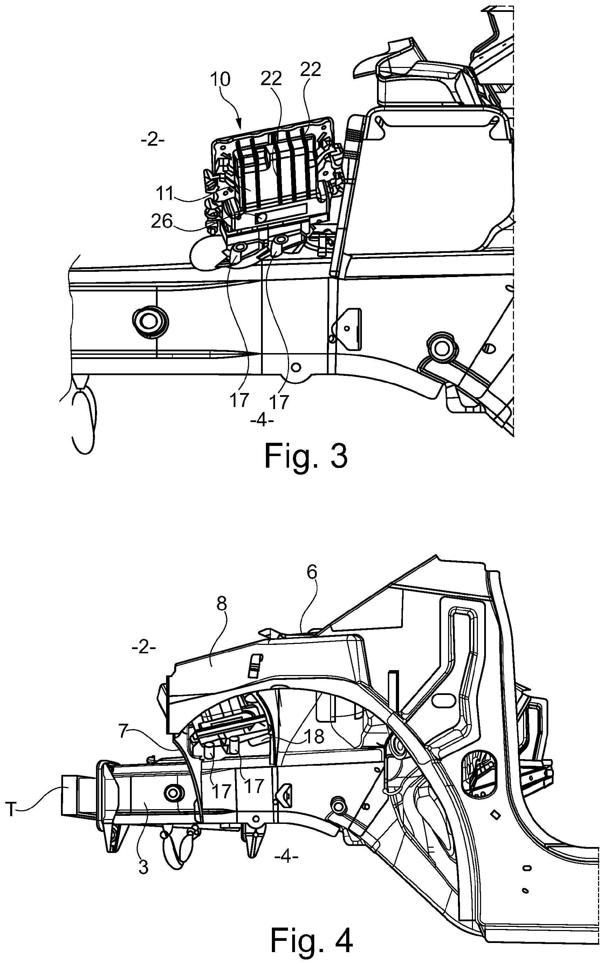

Comme on peut l'observer en figures 3 et 4, la face principale inférieure 11 du boîtier 20 délimite au-dessous d'elle un espace libre, à savoir dépourvu d'autres éléments mécaniques ou électriques. Cet espace libre est délimité en avant par l'entretoise 7, en arrière par la paroi verticale avant de la coupelle d'amortisseur avant gauche 6, et en bas par la paroi de délimitation 5 du passage de roue 4.

L'entretoise 7 présente ici une tranche inférieure arquée pour pouvoir épouser le contour de la paroi de délimitation 5 de passage de roue 4. Cela permet d'isoler davantage l'espace libre du reste du compartiment moteur 2.

Par ailleurs, il existe des techniques de vol qui permettent, en ayant accès aux connecteurs d'un dispositif de contrôle du moteur, de voler un véhicule. Or comme on peut le voir sur ces figures, l'inclinaison du boîtier 20 et l'agencement de ses connecteurs moteurs 17 et du connecteur habitable 18 sur la partie la plus basse du boîtier 20, rend ces connecteurs difficilement accessibles par le haut du compartiment moteur 2. Cela renforce donc la protection de ce véhicule 1 contre le vol.

De même, l'inclinaison du boitier 20, notamment vers le longeron 3, avec les connecteurs 17, 18, sur le bord latéral inférieur 13, protège les connecteurs 17, 18 d'une collision avant car ceux-ci sont en retrait.

De plus, les connecteurs moteur 17 sont orientés vers le groupe motopropulseur et le connecteur habitacle 18 est orienté vers le tablier 9, ce qui nécessite moins de longueur de faisceau électrique. Cette économie de longueur est non négligeable compte tenue du nombre de fils électriques dans les faisceaux électriques F1, F2, plus particulièrement les faisceaux branchés à un dispositif de contrôle du moteur 10.

Dans cet exemple, la face principale inférieure 11 est pourvue d'ailettes 22, qui s'étendent vers le bas, depuis cette face principale inférieure 11, donc à l'intérieur de l'espace libre sous le dispositif de contrôle du moteur 10. Cet espace libre étant logé plus près de l'aile et du passage de roue 4, il contient de l'air plus frais que l'espace du compartiment moteur 2 situé de l'autre côté du boîtier 20. Cela favorise davantage le refroidissement du boîtier 20, et donc des composants électroniques qu'il contient.

Par ailleurs, de fortes variations de température et donc de pression ont lieu à l'intérieur d'un boîtier de dispositif de contrôle du moteur, surtout de dispositif de contrôle du moteur. Pour diminuer ces variations de pression, au moins une ventilation peut être agencée dans le boîtier 20, de manière à communiquer entre l'intérieur et l'extérieur de ce dernier.

Dans cet exemple, l'ouverture d'entrée 26 de cette ventilation débouche vers le bas et dans l'espace libre sous le dispositif de contrôle du moteur 10. Cela permet d'éviter toute entrée d'eau dans le boitier 20, eau qui viendrait du haut du compartiment moteur en cas par exemple du lavage du compartiment moteur à l'eau.

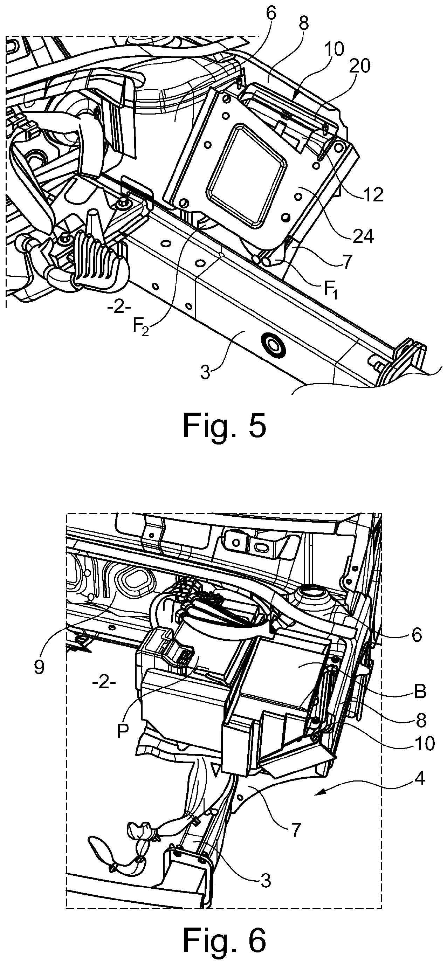

Comme illustré en figure 5, le dispositif de contrôle du moteur 10 est fixé dans le compartiment moteur 2 par l'intermédiaire d'une platine porteuse 24. La face principale supérieure 12 du boitier 20 est plaquée et fixée à cette platine porteuse 24, par les oreilles de fixation 19, qui forment donc les moyens de fixation du dispositif de contrôle du moteur 10 dans le compartiment moteur.

La platine 24 est fixée sur son côté arrière à la coupelle d'amortisseur avant gauche 6 et sur son côté avant à l'entretoise 7. La coupelle d'amortisseur 6 est une pièce de structure se déformant peu. De même, l'entretoise 7 est un élément de la structure qui maintient l'aile. Par conséquent, la platine porteuse 24 est fermement fixée dans le compartiment moteur 2 et résiste bien aux vibrations.

L'agencement du dispositif de contrôle du moteur 10 permet de libérer une place importante entre la paroi latérale 8 et la batterie P.

Dans cet exemple, cette place est utilisée pour agencer une boîte B contenant différents composants électriques. Par exemple, la boîte B peut contenir des relais électriques, des fusibles ou encore des calculateurs pour différents appareils annexes du véhicule 1. L'expression « appareils annexes » est ici employée pour désigner des appareils autres que le groupe motopropulseur ou le dispositif de contrôle du moteur. Ces appareils annexes peuvent être par exemple les essuie-glaces du véhicule. Les calculateurs utilisés pour ces appareils annexes sont encore appelés calculateurs USM.

L'inclinaison du dispositif de contrôle du moteur 10, permet donc un agencement compact à l'intérieur du compartiment moteur 2.

Dans cet exemple, la batterie P est logée à l'arrière du compartiment moteur 2, à proximité du tablier 9 et de la coupelle d'amortisseur 6. Entre cette batterie P et l'aile du véhicule sont logés non seulement le dispositif de contrôle du moteur 10, mais également la boîte B.

## Revendications

1. Véhicule (1) comprenant :
- un compartiment moteur (2),
- un dispositif électrique (10) comprenant un boitier (20) et des composants électriques et/ou électroniques enfermés dans ce boitier,
**caractérisé en ce que** ledit boitier est agencé dans le compartiment moteur au-dessus d'un passage de roue (4) du véhicule et incliné vers le bas en s'éloignant de l'aile du véhicule la plus proche de ce passage de roue vers l'intérieur du compartiment moteur.

2. Véhicule (1) selon la revendication 1, **caractérisé en ce que** ledit dispositif électrique (10) est un dispositif de contrôle du moteur.

3. Véhicule (1) selon la revendication 1 ou 2, **caractérisé en ce que** ledit boitier (20) comprend au moins une connexion électrique destinée à être connectée électriquement à une alimentation électrique (P) du véhicule, ladite au moins une connexion électrique étant orientée vers le bas.

4. Véhicule (1) selon la revendication 3, **caractérisé en ce que** ladite au moins une connexion électrique est agencée sur le côté le plus bas (13) du boitier (20).

5. Véhicule (1) selon l'une des revendications précédentes, **caractérisé en ce que** ledit boitier (20) comprend une face principale inférieure (11) pourvue d'ailettes (22), ces ailettes s'étendant dans un espace agencé entre cette face principale inférieure, une paroi de délimitation (5) du compartiment moteur (2) et du passage de roue (4), et une paroi latérale (8) du compartiment moteur.

6. Véhicule (1) selon l'une des revendications précédentes, **caractérisé en ce que** ledit boitier (20) comprend une ventilation communiquant entre l'extérieur et l'intérieur du boitier, ladite ventilation débouchant sur l'extérieur du boitier par une ouverture extérieure (26) orientée vers le bas.

7. Véhicule (1) selon l'une des revendications précédentes, **caractérisé en ce qu'**il comprend une platine porteuse (24) fixée dans le compartiment moteur (2) et portant ledit dispositif électrique (10).

8. Véhicule (1) selon la revendication 7, **caractérisé en ce que** la platine porteuse (24) est fixée de part et d'autre du boitier (20) à et entre deux parois transversales, agencées entre un longeron (3) du véhicule, et l'aile du véhicule située du côté du passage de roue (4) .

9. Véhicule (1) selon la revendication 8, **caractérisé en ce que** l'une desdites parois transversales est la paroi d'une coupelle d'amortisseur (6) du véhicule et l'autre desdites parois transversales est une entretoise (7) reliant l'aile du véhicule audit longeron (3).

10. Véhicule (1) selon l'une des revendications précédentes, dans lequel le dispositif électrique (10) est logé sous une boite (B) contenant des moyens électriques supplémentaires.

## Patentansprüche

1. Fahrzeug (1), das enthält:
- einen Motorraum (2),
- eine elektrische Vorrichtung (10), die ein Gehäuse (20) und elektrische und/oder elektronische Bauteile enthält, die in diesem Gehäuse eingeschlossen sind,
**dadurch gekennzeichnet, dass** das Gehäuse im Motorraum oberhalb eines Radkastens (4) des Fahrzeugs angeordnet und weg von dem diesem Radkasten am nächsten liegenden Kotflügel des Fahrzeugs zum Inneren des Motorraums nach unten geneigt ist.

2. Fahrzeug (1) nach Anspruch 1, **dadurch gekennzeichnet, dass** die elektrische Vorrichtung (10) eine Kontrollvorrichtung des Motors ist.

3. Fahrzeug (1) nach Anspruch 1 oder 2, **dadurch gekennzeichnet, dass** das Gehäuse (20) mindestens einen elektrischen Anschluss enthält, der dazu bestimmt ist, elektrisch mit einer Stromversorgung (P) des Fahrzeugs verbunden zu sein, wobei der mindestens eine elektrische Anschluss nach unten ausgerichtet ist.

4. Fahrzeug (1) nach Anspruch 3, **dadurch gekennzeichnet, dass** der mindestens eine elektrische Anschluss auf der untersten Seite (13) des Gehäuses (20) angeordnet ist.

5. Fahrzeug (1) nach einem der vorhergehenden Ansprüche, **dadurch gekennzeichnet, dass** das Gehäuse (20) eine untere Hauptseite (11) enthält, die mit Rippen (22) versehen ist, wobei diese Rippen sich in einem Raum erstrecken, der zwischen dieser unteren Hauptseite, einer Begrenzungswand (5) des Motorraums (2) und des Radkastens (4), und einer Seitenwand (8) des Motorraums angeordnet ist.

6. Fahrzeug (1) nach einem der vorhergehenden Ansprüche, **dadurch gekennzeichnet, dass** das Gehäuse (20) eine Belüftung enthält, die zwischen der Außenumgebung und dem Inneren des Gehäuses verbindet, wobei die Belüftung an der Außenseite des Gehäuses durch eine nach unten ausgerichtete äußere Öffnung (26) mündet.

7. Fahrzeug (1) nach einem der vorhergehenden Ansprüche, **dadurch gekennzeichnet, dass** es eine Tragplatte (24) enthält, die im Motorraum (2) befestigt ist und die elektrische Vorrichtung (10) trägt.

8. Fahrzeug (1) nach Anspruch 7, **dadurch gekennzeichnet, dass** die Tragplatte (24) zu beiden Seiten des Gehäuses (20) an und zwischen zwei Querwänden befestigt ist, die zwischen einem Längsträger (3) des Fahrzeugs und dem Kotflügel des Fahrzeugs angeordnet sind, der sich auf der Seite des Radkastens (4) befindet.

9. Fahrzeug (1) nach Anspruch 8, **dadurch gekennzeichnet, dass** eine der Querwände die Wand eines Stoßdämpfertellers (6) des Fahrzeugs und die andere der Querwände ein Abstandshalter (7) ist, der den Kotflügel des Fahrzeugs mit dem Längsträger (3) verbindet.

10. Fahrzeug (1) nach einem der vorhergehenden Ansprüche, wobei die elektrische Vorrichtung (10) unter einem Kasten (B) untergebracht ist, der zusätzliche elektrische Einrichtungen enthält.

## Claims

1. Vehicle (1) comprising:
- an engine compartment (2),
- an electrical device (10) comprising a housing (20) and electrical and/or electronic components enclosed in this housing,
**characterized in that** said housing is arranged in the engine compartment above a wheel arch (4) of the vehicle and is inclined downwards and away from the vehicle wing closest to this wheel arch towards the interior of the engine compartment.

2. Vehicle (1) according to Claim 1, **characterized in that** said electrical device (10) is an engine control device.

3. Vehicle (1) according to Claim 1 or 2, **characterized in that** said housing (20) comprises at least one electrical connection intended to be connected electrically to an electrical power supply (P) of the vehicle, said at least one electrical connection being oriented downwards.

4. Vehicle (1) according to Claim 3, **characterized in that** said at least one electrical connection is arranged on the lowest side (13) of the housing (20).

5. Vehicle (1) according to one of the preceding claims, **characterized in that** said housing (20) comprises a lower main surface (11) provided with fins (22), these fins extending into a space arranged between this lower main surface, a delimiting wall (5) of the engine compartment (2) and of the wheel arch (4), and a lateral wall (8) of the engine compartment.

6. Vehicle (1) according to one of the preceding claims, **characterized in that** said housing (20) comprises an air vent communicating between the exterior and the interior of the housing, said air vent discharging into the exterior of the housing via a downwards-oriented exterior aperture (26).

7. Vehicle (1) according to one of the preceding claims, **characterized in that** it comprises a support plate (24) secured inside the engine compartment (2) and supporting said electrical device (10).

8. Vehicle (1) according to Claim 7, **characterized in that** the support plate (24) is secured to either side of the housing (20) on and between two transverse walls, arranged between a longitudinal member (3) of the vehicle and the wing of the vehicle situated on the side of the wheel arch (4).

9. Vehicle (1) according to Claim 8, **characterized in that** one of said transverse walls is the wall of a shock absorber strut top mount (6) of the vehicle, and the other of said transverse walls is a spacer (7) connecting the wing of the vehicle to said longitudinal member (3).

10. Vehicle (1) according to one of the preceding claims, in which the electrical device (10) is located underneath a box (B) containing additional electrical means.
